(19) Europäisches Patentamt
European Patent Office
Office européen des brevets

(11) Veröffentlichungsnummer : **0 069 966**
**B1**

(12) # EUROPÄISCHE PATENTSCHRIFT

(45) Veröffentlichungstag der Patentschrift : **18.09.85**

(21) Anmeldenummer : **82106009.2**

(22) Anmeldetag : **06.07.82**

(51) Int. Cl.⁴ : **G 03 C 1/56**, G 03 F 7/08, G 03 C 1/94, C 08 G 8/32

(54) **Lichtempfindliches Gemisch auf Basis von o-Naphthochinondiaziden und daraus hergestelltes lichtempfindliches Kopiermaterial.**

(30) Priorität : **14.07.81 DE 3127754**

(43) Veröffentlichungstag der Anmeldung : **19.01.83 Patentblatt 83/03**

(45) Bekanntmachung des Hinweises auf die Patenterteilung : **18.09.85 Patentblatt 85/38**

(84) Benannte Vertragsstaaten : **AT BE CH DE FR GB IT LI NL**

(56) Entgegenhaltungen : **DE-A- 2 146 166**
**Die Akte enthält technische Angaben, die nach dem Eingang der Anmeldung eingereicht wurden und die nicht in dieser Patentschrift enthalten sind.**

(73) Patentinhaber : **HOECHST AKTIENGESELLSCHAFT**
**Postfach 80 03 20**
**D-6230 Frankfurt am Main 80 (DE)**

(72) Erfinder : **Stahlhofen, Paul, Dr. Dipl.-Chem.**
**Leibnizstrasse 18b**
**D-6200 Wiesbaden (DE)**

**EP 0 069 966 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein positiv arbeitendes lichtempfindliches Gemisch, das als lichtempfindliche Verbindung einen Naphthochinon-(1,2)-diazid-(2)-sulfonsäureester eines Kondensationsprodukts aus einem Bisphenol und Formaldehyd enthält und das insbesondere zur Herstellung von Flachdruckplatten bestimmt ist.

Naphthochinondiazidsulfonsäureester von Phenolharzen sind aus der DE-PS 865 860 bekannt. Die mit diesen Verbindungen erhaltenen Kopiermaterialien sind jedoch zu wenig lichtempfindlich und haben eine zu geringe Entwicklerresistenz und Elastizität.

In der DE-OS 21 46 166 sind ähnliche Ester beschrieben, die aus Kondensationsprodukten von Bisphenolen mit Formaldehyd hergestellt worden sind, wobei die beiden Phenolkerne der Bisphenoleinheiten durch Sauerstoff- oder Schwefelatome, Sulfoxy-, Sulfonyl- oder gegebenenfalls substituierte Methylengruppen verbunden sind. Die Methylengruppen können durch Alkylgruppen, Carboxyalkylgruppen und Phenylgruppen substituiert sein. Als Ausführungsbeispiele für Alkylgruppen sind Methyl- und Äthylgruppen beschrieben. Die Verbindungen ergeben Schichten mit guter Entwicklerresistenz und mechanischer Festigkeit. Sie werden in erster Linie zur Herstellung von Ätzschablonen verwendet. Zu ihrer Entwicklung sind jedoch schon relativ stark alkalische Lösungen erforderlich, und ihre Bildschablone hat eine Neigung zur Sprödigkeit, die sich im Offsetdruck bei hohen Auflagen nachteilig bemerkbar macht.

In der älteren europäischen Patentanmeldung 0 068 346 sind Naphthochinon-(1,2)-diazid-(2)-sulfonsäureester von Bis-hydroxyaryl-alkanen beschrieben.

Aufgabe der Erfindung ist es, ein lichtempfindliches Gemisch auf Basis von höhermolekularen Naphthochinondiazidsulfonsäureestern zur Verfügung zu stellen, das Schichten mit hoher Lichtempfindlichkeit, guter Entwickelbarkeit und Entwicklerresistenz, guter Elastizität und Oleophilie ergibt.

Gegenstand der Erfindung ist ein lichtempfindliches Gemisch, das als lichtempfindliche Verbindung einen Naphthochinon-(1,2)-diazid-(2)-sulfonsäureester eines Kondensationsprodukts aus einem Bisphenol und Formaldehyd enthält. Das erfindungsgemäße Gemisch ist dadurch gekennzeichnet, daß der Ester der allgemeinen Formel I

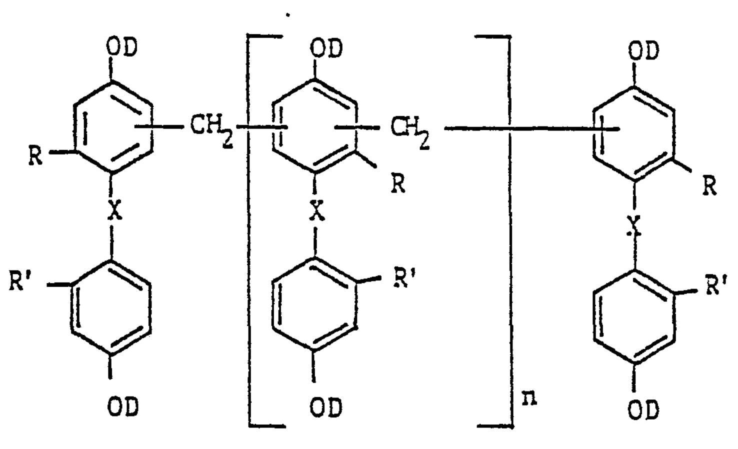

(I)

entspricht, worin

R und R′ Wasserstoffatome oder Alkylgruppen mit 1 bis 4 Kohlenstoffatomen,

X eine gesättigte Alkylen-, Hydroxyalkylen- oder Dihydroxyalkylengruppe mit 6 bis 18 Kohlenstoffatomen,

D den Nazphthochinon-(1,2)-diazid-(2)-sulfonyl-(5)- oder den Naphthochinon-(1,2)-diazid-(2)-sulfonyl-(4)-rest und

n eine Zahl von 1 bis 20

bedeutet.

Die Alkylengruppe X kann linear oder verzweigt sein und bis zu 2 OH-Gruppen enthalten. Von den Verbindungen werden diejenigen bevorzugt, in denen X 8 bis 18 Kohlenstoffatome enthält. Wenn R und R′ Alkylgruppen bedeuten, haben diese 1 bis 4, vorzugsweise 1 Kohlenstoffatom. D ist bevorzugt ein Naphthochinon-(1,2)-diazid-(2)-sulfonyl-(5)-rest.

Die Verbindungen der Formel I werden im allgemeinen hergestellt durch Umsetzen eines Bisphenol-Formaldehyd-Kondensationsprodukts mit einem Naphthochinon-(1,2)-diazid-(2)-sulfonylchlorid. Als bisphenol wird hier eine Verbindung bezeichnet, in der zwei einkernige Hydroxyalkylreste über ein Bindeglied miteinander verbunden sind.

Das Bisphenol-Formaldehyd-Harz, das für die Umsetzung mit dem Naphthochinondiazidsulfonylchlorid verwendet wird, ist ein modifiziertes Phenol-Novolak-Harz, das durch Kondensation eines Bis-(4-hydroxy-aryl)-alkans oder -hydroxy-alkans mit formaldehyd hergestellt wird. Der Formaldehyd wird in

einer Menge von etwa 1 Mol je Mol Bisphenol zugesetzt. Es kann jedoch auch ein überschuß verwendet werden, gegebenenfalls bis zu 2 Mol Formaldehyd auf 1 Mol Bisphenol.

Die Kondensation erfolgt vorteilhaft in organischen Lösungsmitteln, wie Ethanol, 1,4-Dioxan oder Chlorbenzol, in Gegenwart saurer Kondensationsmittel wie Salzäure, Oxalsäure oder p-Toluolsulfonsäure bei einer Reaktionstemperatur von etwa 70 bis 120 °C.

Beispiele für gemäß der vorliegenden Erfindung geeignete Bis-(4-hydroxyaryl)-alkane sind nachfolgend genannt :

1,10-Bis-(4-hydroxy-phenyl)-decan,
1,12-Bis-(4-hydroxy-phenyl)-dodecan,
1,8-Bis-(4-hydroxy-phenyl)-octan,
1,12-Bis-(4-hydroxy-phenyl)-octadecan,
1,12-Bis-(4-hydroxy-2-methyl-phenyl)-dodecan,
1,1-Bis-(4-hydroxy-phenyl)-octan,
1,1-Bis-(4-hydroxy-2-methyl-phenyl)-hexan,
1,1-Bis-(4-hydroxy-phenyl)-dodecan,
1,1-Bis-(4-hydroxy-2-methyl-phenyl)-dodecan,
3,4-Bis-(4-hydroxy-phenyl)-hexan-3,4-diol.

Die Herstellung der Alkylenbisphenole erfolgt derart, daß langkettige Diole mit 2 Mol Phenol in Gegenwart von wasserabspaltenden Verbindungen, wie Bortrifluorid oder zinkchlorid, 3 bis 7 Stunden auf 120 bis 170 °C erhitzt werden. Derartige Verbindungen sind beschrieben in der US-PS 2 321 620 und in J. Am. Chem. Soc. 62, (1940), Seite 143. Auch durch Reduktion der beiden Ketogruppen von Polymethylendiketophenolen, die durch Umsetzung von höheren Paraffindicarbonsäuren mit Phenolen hergestellt werden (Chem. Ber. 74, Seite 1772), lassen sich die entsprechenden Polymethylenbisphenole gewinnen. Die Herstellung von 1,1-Bis-(4-hydroxyaryl)-alkanen erfolgt durch Kondensation von 2 Mol Phenol mit 1 Mol eines höheren aliphatischen Aldehyds in Gegenwart von Salzsäure. Entsprechende Verbindungen sind beschrieben in J. Am. Chem. Soc. 54 (1932), Seite 4325.

Die Verknüpfung der o-Chinondiazidsulfonylgruppen mit den phenolischen Gruppen der Bisphenol-Formaldehyd-Harze erfolgt durch Umsetzung mit Naphthochinon-(1,2)-diazid-(2)-sulfonylchlorid in Analogie zu bekannten Verfahren. Als lichtempfindliche Komponente in den Kopierschichten werden normalerweise solche Verbindungen bevorzugt, in denen alle phenolischen Gruppen verestert sind. Die phenolischen Gruppen können aber auch nur zu einem Teil verestert werden, falls es die kopiertechnischen Eigenschaften der lichtempfindlichen Harze erforderlich machen, z. B. wenn die Löslichkeit in wäßrig-alkalischen Entwicklern sonst nicht ausreichend ist.

Nachfolgend wird die Herstellung eines lichtempfindlichen Bis-(4-hydroxy-aryl)-alkan-Formaldehyd-Harzes in allgemein gehaltener Form beschrieben. Ein Gemisch aus äquimolaren Mengen eines Bis-(4-hydroxy-aryl)-alkans und Formaldehyd in Form einer 37 %igen Formalinlösung wird, falls erforderlich, in der erforderlichen Menge Ethanol heiß gelöst, mit 2 ml konz. Salzsäure versetzt und 1 bis 4 Stunden unter Rückfluß zum Sieden erhitzt. Anstelle von Ethanol kann vorteilhaft auch Dioxan, anstelle einer 37 %igen Formalinlösung Paraformaldehyd und anstelle der Salzsäure auch p-Toluolsulfonsäure verwendet werden. Nach erfolgter Kondensation wird ein Teil des Lösungsmittels abdestilliert und der Rest des Reaktionsgemischs unter starkem Rühren langsam in das 10-fache Volumen Wasser eingegossen. Das ausgefallene Harz wird gut mit Wasser gewaschen und im Rotationsverdampfer oder in einem Vakuumtrockenschrank bei etwa 100 °C getrocknet.

Die Veresterung der phenolischen OH-Gruppen mit o-Naphthochinondiazidsulfonsäure erfolgt derart, daß das Bis-(4-hydroxyaryl)-alkan-Formaldehyd-Kondensationsprodukt in der notwendigen Menge Dioxan oder Aceton gelöst und mit der zur Veresterung der phenolischen Gruppen erforderlichen äquivalenten Menge an o-Naphthochinondiazidsulfonsäurechlorid versetzt wird. Bei 30 °C wird ein 1,5-facher molarer überschuß von Triethylamin als tertiäre Base langsam, vorzugsweise tropfenweise, zugegeben und danach der Ansatz zwei Stunden lang unter Rühren weiter bei 30 °C gehalten. Die Reaktionslösung wird anschließend vom Hydrochlorid der tertiären Base abfiltriert und dann in das 10-fache Volumen Wasser langsam und unter gutem Rühren eingegossen, wobei durch vorherigen Zusatz von wäßriger Salzsäure der pH-Wert zwischen 3 und 6 gehalten wird. Die ausgefallene Diazoverbindung wird abgesaugt, neutral gewaschen und im Vakuum bei Raumtemperatur getrocknet.

Die Konzentration der neuen Naphthochinondiazidsulfonsäureester in der lichtempfindlichen Schicht kann in relativ weiten Grenzen schwanken. Im allgemeinen liegt der Anteil bei 3 bis 50, vorzugsweise zwischen 7 und 25 %, bezogen auf das Gewicht des Feststoffanteils des lichtempfindlichen Gemischs.

Die erfindungsgemäßen lichtempfindlichen Gemische enthalten bevorzugt ferner ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensations-harze haben sich als Zusatz auch bei den erfindungsgemäßen Gemischen mit den neuen

Naphthochinondiazid-sulfonsäureestern als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Als weitere alkalilösliche bzw. in Alkali quellbare Bindemittel sind natürliche Harze, wie Schellack und Kolophonium, und synthetische Harze, wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Die Art und Menge des alkalilöslichen Harzes kann je nach Anwendungszweck verschieden sein ; bevorzugt werden Anteile am Gesamtfeststoff zwischen 95 und 50, besonders bevorzugt 90-65 Gew.-%. Zusätzlich können noch zahlreiche andere Harze mitverwendet werden, bevorzugt Epoxide und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gew.-% vom alkalilöslichen Harz. In geringen Mengen kann das lichtempfindliche Gemisch für spezielle Erfordernisse wie Flexibilität, Haftung, Glanz, Färbung und Farbumschlag etc. außerdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im algemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether, werden besonders bevorzugt.

Als Schichtträger für Schichtdicken unter ca. 10 µm werden meist Metalle verwendet. Für Offsetdruckplatten können eingesetzt werden : walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann, außerdem Mehrmetallplatten z. B. aus Al/Cu/Cr oder aus Messing/Chrom. Für die Herstellung von Hochdruckplatten können die erfindungsgemäßen Gemische auf Zink- oder Magnesium-Platten sowie deren handelsübliche mikrokristalline Legierungen für Einstufenätzverfahren aufgetragen werden, außerdem auf ätzbare Kunststoffe wie Polyoxymethylen. Für Tiefdruckoder Siebdruckformen eignen sich die erfindungsgemäßen Gemische durch ihre gute Haftung und Ätzfestigkeit auf Kupfer- und Nickeloberflächen. Ebenso lassen sich die erfindungsgemäßen Gemische als Photoresists in der Leiterplattenfertigung und beim Formteilätzen verwenden. Für weitere Anwendungen kommen auch andere Träger wie Holz, Papier, Keramik, Textil und andere Metalle in Betracht.

Bevorzugte Träger für dicke Schichten über 10 µm sind Kunststoff-Folien, die dann als temporäre Träger für Transferschichten dienen. Dafür und für Farbprüffolien werden Polyesterfolien, z. B. aus Polyethylenterephthalat, bevorzugt. Polyolefindolien wie Polypropylen sind jedoch ebenfalls geeignet.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag. Schließlich kann die Beschichtung von z. B. Leiterplatten, Glas oder Keramik und Silizium-Scheiben auch durch Schichtübertragung von einem temporären Träger erfolgen. Belichtet wird mit den in der Technik üblichen Lichtquellen. Auch das Bestrahlen mit Elektronen oder Lasern stellt eine Möglichkeit zur Bebilderung dar.

Die zum Entwickeln verwendeten wäßrig-alkalischen Lösungen abgestufter Alkalität, vorzugsweise mit einem pH im Bereich von 10-13, die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemäßen lichtempfindlichen Gemische bei der Herstellung von Druckformen, d.h. insbesondere Offset-, autotypischen Tiefdruck- und Siebdruckformen, in Kopierlacken und sogenannten Trockenresists.

Die unter Verwendung der neuen Verbindungen hergestellten lichtempfindlichen Schichten besitzen eine hohe praktische Lichtempfindlichkeit, bei guter Filmbildung auf den üblichen Trägermaterialien, sowie eine verbesserte Elastizität und Resistenz gegenüber alkalischen Entwicklern. Die bevorzugten Verbindungen selbst zeichnen sich durch eine gute Löslichkeit in den üblichen Lösungsmitteln, durch eine starke Oleophilie sowie durch eine gute Verträglichkeit mit den übrigen Bestandteilen der Kopierschicht aus.

Die Erfindung wird an Hand der folgenden Beispiele näher erläutert, in denen Gewichtsteile (Gt) und Volumteile (Vt) im Verhältnis von g zu $cm^3$ stehen. Prozente sind, wenn nichts anderes angegeben ist, Gewichtsprozente.

## Beispiel 1

Mit einer Lösung von

1,00 Gt des Veresterungsproduktes aus 8,0 Gt 1,1-Bis-(4-hydroxy-2-methyl-phenyl)-dodecan-Formaldehydharz und 10,7 Gt Naphthochinon-(1,2)-diazid-(2)-5-sulfonsäurechlorid,
6,20 Gt eines Kresol-Formaldehyd-Novolaks mit einem Erweichungspunkt von 105-120 °C nach DIN 53 181,
0,12 Gt 4-(p-Tolylmercapto)-2,5-diethoxy-benzoldiazoniumhexafluorophosphat und
0,06 Gt Kristallviolett in
40 Gt Ethylenglykolmonomethylether und
50 Gt Tetrahydrofuran

wurde eine elektrolytisch aufgerauhte und anodisierte Aluminiumplatte mit einem Oxidgewicht von 3,0 g/m$^2$ beschichtet.

Das so hergestellte vorsensibilisierte Material mit einem Schichtgewicht der lichtempfindlichen Schicht von 2,50 g/m$^2$ wurde unter einer transparenten Positiv-Vorlage bildmäßig belichtet und anschließend mit der folgenden Lösung entwickelt:

5,3 Gt Natriummetasilikat × 9 Wasser
3,4 Gt Trinatriumphosphat × 12 Wasser
0,3 Gt Natriumdihydrogenphosphat (wasserfrei) in
91,0 Gt Wasser.

Durch die Entwicklung wurden die von Licht getroffenen Anteile der Kopierschicht entfernt, und es blieben die unbelichteten Bildstellen auf dem Schichtträger zurück. Von der so hergestellten Druckform wurden in einer Offsetmaschine etwa 250 000 einwandfreie Drucke hergestellt. Die Druckschablone zeichnete sich durch eine ausgezeichnete Elastizität, Oleophilie, Entwicklerresistenz und Haftung auf dem Träger aus.

In den folgenden Beispielen werden weitere Beschichtungslösungen angegeben, mit denen ähnliche Ergebnisse erhalten wurden. Wenn nicht gesondert vermerkt, entsprechen Herstellung und Verarbeitung der damit erhaltenen Druckplatten den in Beispiel 1 beschriebenen Bedingungen.

## Beispiel 2

Mit einer Lösung von

1,10 Gt des Veresterungsproduktes aus 8,0 Gt 1,12-Bis-(4-hydroxy-2-methyl-methyl-phenyl)-dodecan-Formaldehydharz und 10,7 Gt Naphthochinon-(1,2)-diazid-(2)-5-sulfonsäurechlorid,
6,10 Gt des in Beispiel 1 angegebenen Novolaks
0,12 Gt 4-(p-Tolylmercapto)-2,5-diethoxybenzol-diazonium-hexafluorophosphat und
0,07 Gt Kristallviolett in
40 Gt Ethylenglykolmonomethylether und
50 Gt Tetrahydrofuran

wurde eine elektrolytisch aufgerauhte und anodisierte Aluminiumplatte beschichtet. Der anodisierte Aluminium-Träger war vor dem Aufbringen der lichtempfindlichen Kopierschicht mit einer wäßrigen Lösung von Polyvinylphosphonsäure behandelt worden, wie es in der DE-PS 16 21 478 beschrieben ist.

## Beispiel 3

Mit einer Lösung von

1,10 Gt des Veresterungsproduktes aus 16,4 Gt 3,4-Bis-(4-hydroxy-phenyl)-hexan-3,4-diol-Formaldehydharz und 26,8 Gt Naphthochinon-(1,2)-diazid-(2)-5-sulfonsäurechlorid,
6,20 Gt des in Beispiel 1 angegebenen Novolaks
0,12 Gt 4-(p-Tolylmercapto)-2,5-diethoxy-benzoldiazoniumhexafluorophosphat und
0,07 Gt Kristallviolett in
40 Gt Ethylenglykolmonomethylether und
50 Gt Tetrahydrofuran

wurde eine elektrolytisch aufgerauhte und anodisierte Aluminiumplatte beschichtet, die mit einer wäßrigen Lösung von Polyvinylphosphonsäure nachbehandelt worden war.

Beispiel 4

Mit einer Lösung von

1,10 Gt des Veresterungsproduktes aus 37,6 Gt 1,1-Bis-(4—hydroxy-phenyl)-dodecan-Formaldehydharz und 53,6 Gt Naphthochinon-(1,2)-diazid-(2)-5-sulfonsäurechlorid,
6,00 Gt des in Beispiel 1 angegebenen Novolaks,
0,15 Gt Naphthochinon-(1,2)-diazid-(2)-4-sulfonsäurechlorid,
0,10 Gt 2,3,4-Trihydroxy-benzophenon und
0,07 Gt Kristallviolett in
40 Gt Ethylenglykolmonomethylether und
50 Gt Tetrahydrofuran

wurde eine elektrolytisch aufgerauhte und anodisierte Aluminiumplatte beschichtet.

Beispiel 5

Mit einer Lösung von

1,10 Gt des Veresterungsproduktes aus 33,8 Gt 1,10-Bis-(4-hydroxy-phenyl)-decan-Formaldehydharz und 53,6 Gt Naphthochinon-(1,2)-diazid-(2)-5-sulfonsäurechlorid,
6,20 Gt des in Beispiel 1 angegebenen Novolaks,
0,12 Gt 4-(p-Tolylmercapto)-2,5-diethoxy-benzoldiazoniumhexafluorophosphat und
0,06 Gt Kristallviolett in
40 Gt Ethylenglykolmonomethylether und
50 Gt Tetrahydrofuran

wurde eine elektrolytisch aufgerauhte und anodisierte Aluminiumplatte mit einem Oxidgewicht von 3,0 g/m² beschichtet, die wie in Beispiel 2 mit Polyvinylphosphonsäure behandelt worden war.

**Patentansprüche**

1. Lichtempfindliches Gemisch, das als lichtempfindliche Verbindung einen Naphthochinon-(1,2)-diazid-(2)-sulfonsäureester eines Kondensationsprodukts aus einem Bisphenol und Formaldehyd enthält, dadurch gekennzeichnet, daß der Ester der allgemeinen Formel I

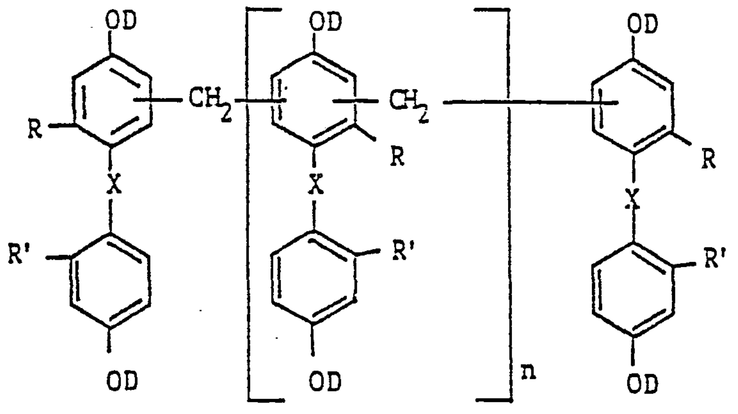

(I)

entspricht, worin
R und R' Wasserstoffatome oder Alkylgruppen mit 1 bis 4 Kohlenstoffatomen,
X eine gesättigte Alkylen-, Hydroxyalkylen- oder Dihydroxyalkylengruppe mit 6 bis 18 Kohlenstoffatomen,
D den Naphthochinon-(1,2)-diazid-(2)-sulfonyl-(5)- oder den Naphthochinon-(1,2)-diazid-(2)-sulfonyl-(4)-rest und
n eine Zahl von 1 bis 20
bedeutet.

2. Lichtempflindliches Gemisch nach Anspruch 1, dadurch gekennzeichnet, daß es zusätzlich ein wasserunlösliches, in wäßrig-alkalischen Lösungen lösliches oder mindestens quellbares Bindemittel enthält.

3. Lichtempfindliches Gemisch nach Anspruch 2, dadurch gekennzeichnet, daß das Bindemittel ein Novolak ist.

4. Lichtempfindliches Gemisch nach Anspruch 2, dadurch gekennzeichnet, daß es 3 bis 50 Gew.-% des Esters der Formel I, bezogen auf seinen Gehalt an nichtflüchtigen Bestandteilen, enthält.

5. Lichtempfindliches Kopiermaterial aus einem Schichtträger und einer lichtempfindlichen Schicht, die als lichtempfindliche Verbindung einen Naphthochinon-(1,2)-diazid-(2)-sulfonsäureester eines kondensationsprodukts aus einem Bisphenol und Formaldehyd enthält, dadurch gekennzeichnet, daß der Ester der allgemeinen Formel I

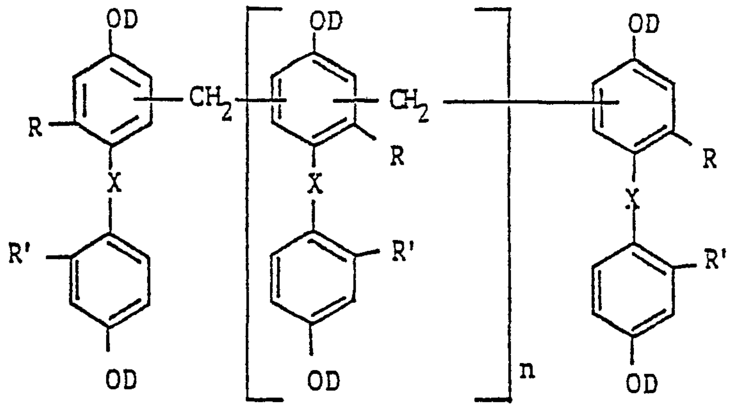

(I)

entspricht, worin

R und R' Wasserstoffatome oder Alkylgruppen mit 1 bis 4 Kohlenstoffatomen,

X eine gesättigte Alkylen-, Hydroxyalkylen- oder Dihydroxyalkylengruppe mit 6 bis 18 Kohlenstoffatomen,

D den Naphthochinon-(1,2)-diazid-(2)-sulfonyl-(5)- oder den Naphthochinon-(1,2)-diazid-(2)-sulfonyl-(4)-rest und

n eine Zahl von 1 bis 20

bedeutet.

6. Lichtempfindliches Kopiermaterial nach Anspruch 5, dadurch gekennzeichnet, daß der Schitträger aus Aluminium besteht.

7. Lichtempfindliches Kopiermaterial nach Anspruch 6, dadurch gekennzeichnet, daß das Aluminium elektrolytisch aufgerauht und anodisch oxydiert ist.

**Claims**

1. A light-sensitive mixture which contains, as the light-sensitive compound, a 1,2-naphthoquinone-2-diazide-sulfonic acid ester of a condensation product formed from a bisphenol and formaldehyde, wherein the ester corresponds to the general formula I

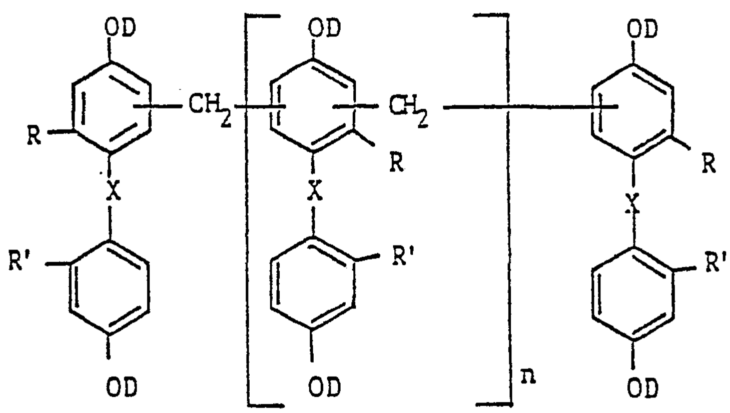

(I)

in which

R and R' denote hydrogen atoms or alkyl groups having 1 to 4 carbon atoms,

X denotes a saturated alkylene, hydroxyalkylene or dihydroxyalkylene group having 6 to 18 carbon atoms,

D denotes the 1,2-naphthoquinone-2-diazide-5-sulfonyl radical or the 1,2-naphthoquinone-2-diazide-4-sulfonyl radical and

n denotes a number from 1 to 20.

2. A light-sensitive mixture as claimed in claim 1, which additionally contains a binder which is insoluble in water, but soluble or at least swellabe in aqueous-alkaline solutions.

3. A light-sensitive mixture as claimed in claim 2, wherein the binder is a novolak.

4. A light-sensitive mixture as claimed in claim 2, which contains 3 to 50 % by weight of the ester of the formula I, relative to its content of non-volatile constituents.

5. A light-sensitive copying material composed of a layer support and a light-sensitive layer containing, as the light-sensitive compound, a 1,2-naphthoquinone-2-diazide sulfonic acid ester of a condensation product formed from a bisphenol and formaldehyde, wherein the ester corresponds to the general formula I

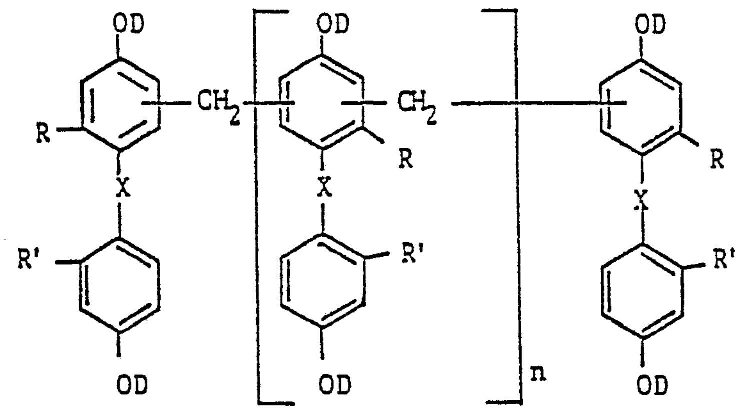

(I)

in which

R and R′ denote hydrogen atoms or alkyl groups having 1 to 4 carbon atoms,

X denotes a saturated alkylene, hydroxyalkylene or dihydroxyalkylene group having 6 to 18 carbon atoms,

D denotes the 1,2-naphthoquinone-2-diazide-5-sulfonyl radical or the 1,2-naphthoquinone-2-diazide-4-sulfonyl radical and

n denotes a number from 1 to 20.

6. A light-sensitive copying material as claimed in claim 5, wherein the layer support consists of aluminium.

7. A light-sensitive copying material as claimed in claim 6, wherein the aluminium has been electrolytically roughened and anodically oxidized.

**Revendications**

1. Mélange photosensible qui contient comme composé photosensible un ester naphtoquinone-(1,2)-diazide-(2)-sulfonique d'un produit de condensation d'un bisphénol et de formaldéhyde, caractérisé en ce que l'ester correspond à la formule générale I :

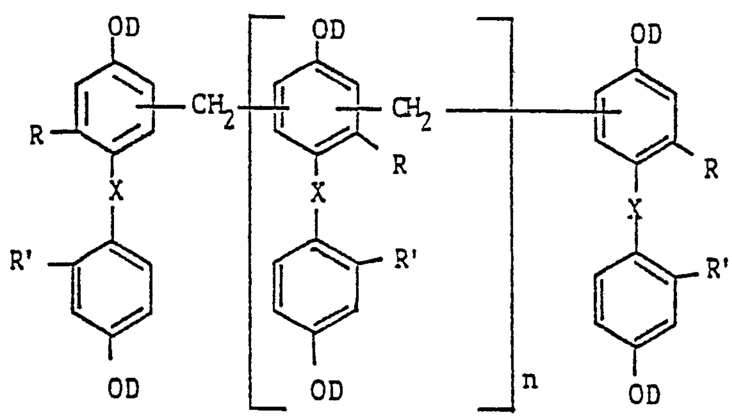

(I)

dans laquelle

R et R′ représentent des atomes d'hydrogène ou des groupes alcoyle à 1 à 4 atomes de carbone,

X représente un groupe alcoylène, hydroxyalcoylène ou dihydroxxyalcoylène saturé ayant 6 à 18 atomes de carbone,

D représente le radical naphtoquinone-(1,2)-diazide-(2)-sulfonyle-(5) ou naphtoquinone-(1,2)-diazide-(2)-sulfonyle-(4) et

n est un nombre de 1 à 20.

2. Mélange photosensible selon la revendication 1, caractérisé en ce qu'il contient en outre un liant

insoluble dans l'eau, soluble ou du moins gonflable dans les solutions alcalines aqueuses.

3. Mélange photosensible selon la revendication 2, caractérisé en ce que le liant est un Novolak.

4. Mélange photosensible selon la revendication 2, caractérisé en ce qu'il contient 3 à 50 % en poids de l'ester de formule I par rapport à sa teneur en constituants non volatils.

5. Matériau de reprographie photosensible constitué par un support de couche et une couche photosensible, qui contient comme composé photosensible un ester naphtoquinone-(1,2)-diazide-(2)-sulfonique d'un produit de condensation d'un bisphénol et de formaldéhyde, caractérisé en ce que l'ester correspond à la formule générale I

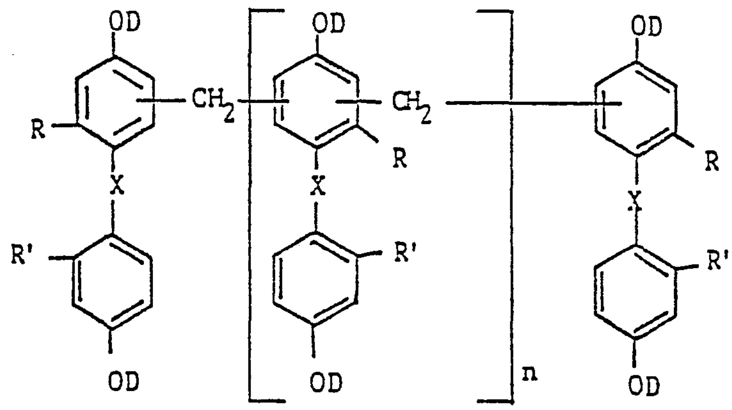

(I)

dans laquelle

R et R' représentent des atomes d'hydrogène ou des groupes alcoyle à 1 à 4 atomes de carbone,

X représente un groupe alcoylène, hydroxyalcoylène ou dihydroxyalcoylène saturé ayant 6 à 18 atomes de carbone,

D représente le radical naphtoquinone-(1,2)-diazide-(2)-sulfonyle-(5) ou naphtoquinone-(1,2)-diazide-(2)-sulfonyle-(4) et

n est un nombre de 1 à 20.

6. Matériau de reprographie photosensible selon la revendication 5, caractérisé en ce que le support de couche est en aluminium.

7. Matériau de reprographie photosensible selon la revendication 6, caractérisé en ce que l'aluminium est dépoli par électrolyse et oxydé anodiquement.